# EUROPEAN PATENT APPLICATION

(11) **EP 4 733 017 A1**
(43) Date of publication of application: **29.04.2026**
(21) Application number: 24848007.1
(22) Date of filing: 15.07.2024
(51) Int. Cl.: B25J 19/02, B25J 18/00

(54) **ELECTRONIC SKIN, MECHANICAL ARM, AND INTELLIGENT ROBOT**

(30) Priority: 28.07.2023 CN 202310947048
(71) Applicant: Beijing Tashan Technology Co., Ltd., Beijing 102308 (CN)
(72) Inventor: SUN, Tengchen, Beijing 102308 (CN); ZENG, Fanyou, Beijing 102308 (CN); WANG, Zhen, Beijing 102308 (CN)
(74) Representative: Yang, Shu
(86) International application number: PCT/CN2024/105411
(87) International publication number: WO 2025/026048

(57) **Abstract**

The present invention relates to an electronic skin, robotic arm, and intelligent robot comprising a CDC, a switch array, a processing module, and an electrode layer. The electrode layer is affixed to a first external object and includes at least three sensing electrodes distributed at different positions. The CDC couples each sensing electrode via the switch array to selectively parallel any one or more sensing electrodes, forming a self-capacitance detection electrode. Different selections create variations in the area of each formed capacitance detection electrode, thereby obtaining their respective self-capacitance values to form a combination; and/or for selectively combining any at least two sensing electrodes to form a pair of mutual capacitance detection electrode groups, and through different selections, causing differences in the area or spacing of the two electrodes in each formed pair of mutual capacitance detection electrode groups to obtain the mutual capacitance values of each mutual capacitance detection electrode group to form a combination; a processing module, coupled to the CDC, for outputting the distance and/or speed of the second external object based on the combination.

## Description

### Technical Field

The present invention relates to a robot, a robotic arm, and an electronic skin wrapped around the outer surface of the robotic arm.

### Background

Robotic arms are complex systems characterized by high precision, high nonlinearity, and strong coupling. Due to their operational flexibility, they have been widely adopted in industrial applications.

Operator safety remains a critical concern during robotic arm operations. Preventing accidental collisions between the robotic arm and human bodies to avoid injury is of paramount importance for robotic arm tasks.

Among robotic arm collision avoidance technologies, capacitive sensing is favored for its advantages in ease of deployment, structural simplicity, and cost-effectiveness. Existing mature capacitive-to-digital conversion circuits (CDC), such as the DAI7142 and ADI7147, employ Δ-Σ modulation. This method involves repeatedly charging and discharging the measured capacitance and comparing it to a reference capacitance (See: US Patent No. 5,134,401). This approach directly converts the measured capacitance value into a digital value, achieving measurement sensitivity at the 1 pF level. It readily meets the sensitivity requirements of capacitance measurement systems while offering immunity to stray capacitance. Notably, these chips feature multiple channels in their design, simplifying circuit layout and effectively reducing both cost and installation complexity.

Patent Document 202220470898.9 discloses an electronic skin, robotic arm, and robot. The electronic skin comprises an insulating substrate, an inductive coil, and two planar electrodes. The planar electrodes form a self-capacitance with approaching conductors, while the inductive coil can form a coupled inductance with approaching conductors or non-conductors. This enables detection of approaching conductors and non-conductors, preventing collisions by the robotic arm. Patent Document 202220470898.9 employs a combined approach of self-capacitance and coupled inductance, requiring both electrode and inductive coil arrangements. This results in a complex structure with high costs. Furthermore, self-capacitance offers low detection accuracy for approaching objects and poor differentiation between object proximity distance and velocity. Patent Document 202110581850.5 discloses a robotic arm that avoids obstacles by monitoring proximity through electronic skin data. The electronic skin detects obstacles by forming capacitor plates via electrodes, again relying on self-capacitance detection. This approach similarly suffers from accuracy limitations in detecting distance and speed.

### Summary of the Invention

The present invention provides a collision avoidance solution for robotic arms. It offers structural and cost advantages due to the ease of electrode placement and convenient sensor-to-chip coupling, along with immunity to stray capacitance. Simultaneously, it achieves high discrimination between object proximity distance and velocity, ensuring superior detection accuracy.

To this end, an electronic skin is provided, comprising a capacitance-to-digital converter (CDC), a switch array, a processing module, and an electrode layer. The electrode layer is insulated and affixed to a first external object for proximity sensing, featuring at least three sensing electrodes distributed at different positions. The capacitance-to-digital conversion circuit couples each sensing electrode via the switch array to selectively parallel any one or more sensing electrodes, forming a self-capacitance detection electrode. Different selections create variations in the area of each formed self-capacitance detection electrode, enabling the acquisition of their respective self-capacitance values to form a combination. and/or selectively combines at least two sensing electrodes to form a pair of mutual capacitance detection electrode groups. Different selections create variations in the area or spacing between the two electrodes within each pair of mutual capacitance detection electrode groups, thereby obtaining the mutual capacitance values of each mutual capacitance detection electrode group to form a combination; The processing module, coupled with the capacitance-to-digital conversion circuit, outputs the distance and/or speed at which a second external object approaches the electronic skin based on the combination.

This invention leverages the structural cost advantages afforded by the easy arrangement of electrodes while combining the benefits of CDC to achieve immunity to stray capacitance and reduced installation complexity. More importantly:
By independently implementing the variable-area self-capacitance scheme-selectively paralleling any one or more sensing electrodes to form a self-capacitance detection electrode-the self-capacitance values of each detection electrode are obtained to form a combination. Due to differing electrode areas (variable area) between detection electrodes, the self-capacitance electrode area progressively increases. Larger areas enable longer self-capacitance detection distances, creating multiple detection ranges. This achieves high differentiation for distance and speed (convertible from distance), thereby enhancing detection accuracy.

Alternatively, by implementing either the variable mutual capacitance area or variable mutual capacitance spacing scheme independently, i.e., by selectively combining any two or more sensing electrodes to form a pair of mutual capacitance detection electrode groups, the mutual capacitance values of each mutual capacitance detection electrode group are obtained to form a combination. Similarly, due to the differing areas or spacings (variable area or variable spacing) between the two electrodes in each pair of mutual capacitance detection electrode groups, as the mutual capacitance gap and/or area decreases, the detection distance also shortens, creating multiple levels to enhance detection accuracy;

Alternatively, the "combined" approach implements both variable self-capacitance area and variable mutual capacitance area or spacing. Self-capacitance provides overall long-range detection, while mutual capacitance enables close-range detection (within 5 cm) with higher resolution. Coordinating both expands the detection range and enhances accuracy, achieving both wide detection coverage and high precision.

In this invention, the first external object is not limited to robotic arms but can be any object requiring proximity sensing. The second external object may be conductive (e.g., the human body) or non-conductive, provided its dielectric constant differs sufficiently from air's (e.g., exceeding a set threshold). The capacitive sensing electric field then detects dielectric constant variations within its range for identification.

As an improved solution, when electronic skin is deployed on the first external object, it comprises at least two segments distributed across different regions of the object. For robotic arms, segments may form multiple sub-zones on a single arm or distribute across all arms, with zoning tailored to specific sensing scenarios. simultaneously, each electronic skin is configured to operate in a time-division manner to avoid mutual crosstalk. More preferably, each electronic skin is configured to transmit digital signals via a digital router to achieve rapid collaborative operation. In this case, the central processing module is coupled with the digital router to calculate the optimal avoidance motion path for the robotic arm. In this invention, the digital router-related content may refer to CN202110957228.X, and will not be elaborated upon here.

As an alternative improvement, when the surface of the first external object is conductive-such as when the robotic arm's housing is typically metal for load-bearing and structural integrity-the sensing electrodes may be configured as strip electrodes or mesh electrodes. This design ensures that the outer contour area of the electrodes-their sensing area-remains unchanged by forming them into strips or a mesh through perforation. This approach maximizes the sensing area without reduction while minimizing the impact of the robotic arm's own distributed capacitance to the ground, thereby enhancing detection accuracy. Additionally, the strip or mesh shape offers secondary benefits such as improved heat dissipation and reduced electrode installation costs. Building upon this, the perforation rate of strip or mesh electrodes is configured between 50% and 90%. The significance of this perforation rate in proximity sensing for primary external objects like robotic arms is explained below. Electrodes possess front and back sides. Assuming the back side faces the robotic arm while the front side faces secondary external objects like the human body, we know that capacitance primarily depends on the distance and area between the object and the electrode. Since the electrode is mounted on the robotic arm, the distance between its back side and the arm remains fixed. the parasitic capacitance between the electrode and the robotic arm depends on the projected area of the electrode on the arm. This projected area is directly related to the electrode's open area ratio. It can be concluded that a higher open area ratio results in a smaller projected area of the electrode on the robotic arm, leading to lower parasitic capacitance between them. This enhances detection sensitivity and improves accuracy. Conversely, in proximity sensing between the electrode's front surface and secondary external objects like the human body, distance predominantly influences the capacitance between the body and the electrode (this capacitance is desirable and can be termed the effective measurement capacitance). Increasing the aperture ratio conversely reduces the sensing distance of the effective measurement capacitance. Consider these examples for further clarification: In the first scenario, with a solid electrode, assume the capacitance value detected by CDC when a human approaches within 5 cm of the electrode's front face is 100. At this point, the parasitic capacitance between the electrode and robotic arm is 1000. In the second scenario, with perforated electrodes, the capacitance value reaches 100 only when the human body approaches within 3 cm of the electrode front. Since the parasitic capacitance between the perforated electrode and the robotic arm becomes 200, the change rate shifts from 100/1000 to 100/200-a significant increase. In other words, signal sensitivity is greatly enhanced. It is evident from the above that distance and accuracy represent a conflicting trade-off in robotic arm proximity detection. Through extensive experimentation, we found that a perforation rate between 50% and 90% for strip or mesh electrodes optimally balances reliability, detection range, and accuracy, yielding the best detection performance. 50% serves as the first critical threshold-exceeding this point causes significant changes in parasitic capacitance. while 90% represents another critical threshold. Exceeding this point results in an excessively short detection range for human proximity sensing, posing significant challenges to the timeliness and reliability of avoidance responses.

As an alternative improvement, the electronic skin incorporates an outer insulating protective layer and an inner insulating layer applied to both sides of the electrode layer. The inner insulating layer contacts the first external object-such as the outer surface of a robotic arm-providing comprehensive protection, fixation, and isolation for the electrode layer while facilitating installation and deployment. As a further refinement of this approach, when deployed on a robotic arm-where the first external object's surface is conductive-the inner insulation layer is configured with a thickness of at least 1mm. This increases the distance between electrodes and the robotic arm, reducing parasitic capacitance between them. Alternatively, the electronic skin may include an intermediate insulating layer and an active shielding layer positioned between the electrode layer and the inner insulating layer. The active shielding layer is designed to shield the electrode layer from detection interference caused by the robotic arm, with the electrode layer adhered to the intermediate insulating layer.

A robotic arm is also provided, with the aforementioned electronic skin laminated onto its outer surface. When the robotic arm's probe or manipulator head incorporates capacitive sensors-such as when the robotic arm is used for capacitive detection applications on the human body (e.g., measuring skin parameters or assessing cosmetic effects on skin)-the wide detection range of the electronic skin enables the robotic arm to position all components except the probe or manipulator head as far as possible from the human body. minimizing the robot arm's proximity to the human body. This reduces the impact of the robot arm's distributed capacitance on the human body, thereby enhancing the accuracy of the capacitive sensor's measurements on the probe or manipulator head. In other words, employing the electronic skin of the present invention on a robotic arm equipped with capacitive sensors on such probes or manipulators yields significant technical advantages.

The present invention further provides an intelligent robot comprising the aforementioned robotic arm.

### Brief Description of the Drawings

Figure 1 shows a schematic diagram of the electronic skin structure;
Figure 2 shows a distribution schematic of the electronic skin on a first external object;
Figure 3 shows a schematic diagram of the sensing electrode shape;
Figure 4-1 shows a schematic diagram of different self-capacitance electric field line distributions formed by sensing electrodes of varying areas;
Figure 4-2 shows a schematic diagram of self-capacitance electric field line distribution formed by coupling different sensing electrodes;
Figure 5 shows a schematic diagram of mutual capacitance electric field line distribution formed by different sensing electrodes;
Figure 6 shows a schematic diagram of the relative relationship between the first external object and the sensing electrodes;
Figure 7 shows a schematic diagram of the refined structure of the electronic skin;
Figure 8 shows a schematic diagram of the structure of the robotic arm equipped with the electronic skin.

### Detailed Description

The technical solutions of the embodiments of the present invention will now be described in detail with reference to the accompanying drawings.

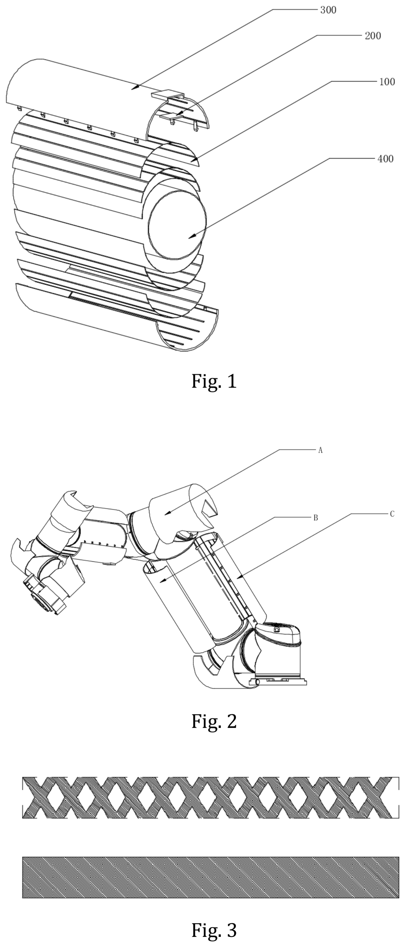

As shown in Figure 1, the electronic skin primarily comprises an electrode layer 100, a processing module 200, an outer insulating layer 300, and an inner insulating layer 400. The processing module 200 includes a capacitive-to-digital conversion circuit and a switch array. The electrode layer 100 comprises at least three sensing electrodes 101 distributed at different positions.

As shown in Figure 2, the electronic skin is configured in at least two units, such as electronic skins A, B, and C, distributed at different positions on the first external object. Different electronic skins operate independently in a time-sharing manner, with digital signals transmitted between them via a digital router.

As shown in Figure 3, the sensing electrodes 101 of the electronic skin's electrode layer 100 may be shaped as strips (as illustrated) or as a grid. Shaping them as strips or a grid increases the open area ratio of the sensing electrodes' normal projection area relative to the first external object. When the first external object 600 is a robotic arm, whose housing is typically made of metal, Increasing the open area ratio reduces the parasitic capacitance between the sensing electrode and the first external object, thereby enhancing sensitivity, improving heat dissipation conditions, and lowering installation costs. Simultaneously, it maximizes the open area ratio and sensitivity while ensuring reliability.

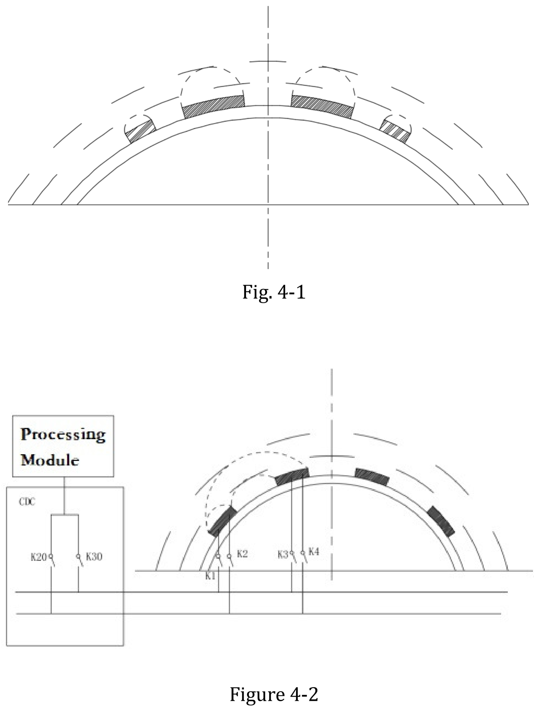

As shown in Figure 4-1, the distribution of electric field lines from the self-capacitance varies with the area of the sensing electrode. Larger sensing electrodes exhibit more widely distributed field lines, enabling a larger detection radius. Smaller sensing electrodes have more closely distributed field lines, offering higher sensitivity for close-range detection. This allows detection of the approach of a second external object at a distance. By utilizing sensing electrodes of different areas, precise detection of the second external object at varying distances can be achieved.

As shown in Figure 4-2, variations in sensing electrode area can be achieved by the CDC coupling multiple sensing electrodes via a switch array. Selectively paralleling at least one sensing electrode forms a mutual capacitance detection electrode. Altering the number of paralleled electrodes achieves changes in the sensing electrode area.

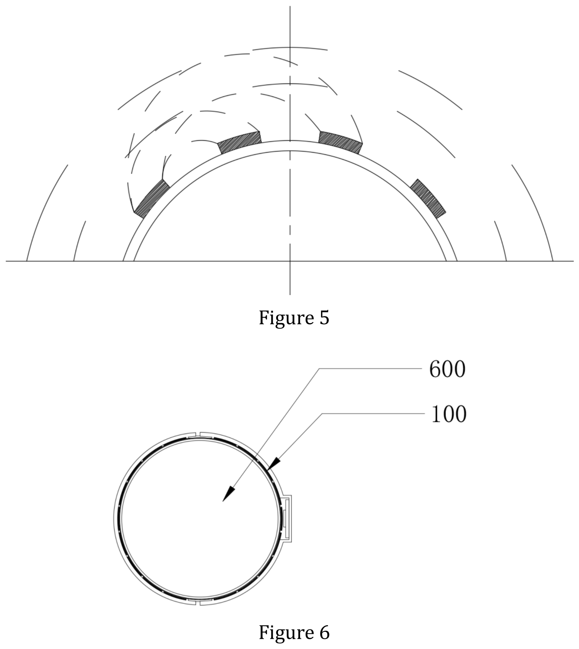

As illustrated in Figure 5, coupling different combinations of sensing electrodes via the switch array creates distinct mutual capacitances. The distribution of electric field lines formed by the two sets of mutual capacitances correlates with the area and spacing of the sensing electrodes constituting the mutual capacitance. Consequently, different mutual capacitances produce distinct electric field line distributions, enabling detection of secondary external objects at varying distances. This achieves multi-level distance detection and enhances detection sensitivity. As illustrated in Figures 4-1, 4-2, and 5, both approaches enable detection of the second external object at different positions. While the self-capacitance detects at longer ranges, the mutual capacitance detects at shorter distances. This expands the detection range, enables multi-level distance detection, and allows conversion of distance-based capacitance changes into the movement speed of the second external object. When configured on the first external object, at least two electronic skin modules are distributed at different positions on the first external object 600. Digital signals are transmitted between the electronic skin modules via a digital router, enabling rapid collaborative operation. The central processing module couples with the digital router to compute the optimal avoidance path for the robotic arm.

As shown in Figure 6, the insulated electrode layer 100 adheres to the outer surface of the first external object 600. The aperture rate of the electrode layer 100 is configured between 50% and 90%, effectively balancing reliability, detection range, and accuracy.

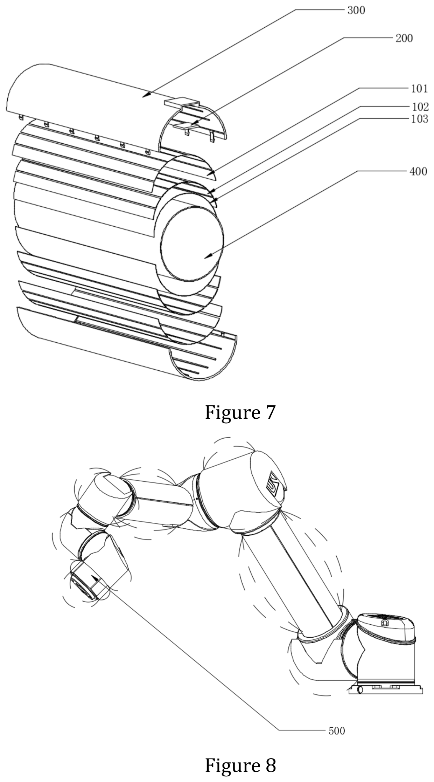

As shown in Figure 7, the outer layer of the electronic skin features an outer insulating protective layer 300 and an inner insulating layer 400. The electrode layer 100 comprises sensing electrodes 101, an intermediate insulating layer 102, and an active shielding layer 103. When the surface of the first external object 600 is conductive, the active shielding layer 103 shields the detection influence of the first external object 600 on the electrode layer. The active shielding layer 103 is bonded to the sensing electrode 101 via the intermediate insulating layer 102, which may be configured as an insulating material with double-sided adhesive backing. The thickness of the inner insulating layer 400 is at least greater than 1 mm, reducing the parasitic capacitance between the first external object 600 and the sensing electrode 101 to ensure insulation effectiveness.

As shown in Figure 8, when the first external object 600 is a robotic arm equipped with a detection probe 500 at its head, for skin detection on the human body, the robotic arm may be equipped with multiple electronic skin panels distributed at different positions. The central processing module calculates the maximum distance between each part of the robotic arm (excluding the detection probe 500) and the human body, thereby reducing the influence of the robotic arm's distributed capacitance on the human body. This enhances the accuracy of the capacitive sensor's detection results on the probe or operating head.

Finally, it should be noted that the above embodiments are provided to illustrate the technical solutions of the present invention and do not constitute limitations on the scope of protection of the invention. Although the invention has been described in detail with reference to preferred embodiments, those skilled in the art will understand that modifications or equivalent replacements to the technical solutions of the invention may be made without departing from the essence and scope of the technical solutions of the invention.

## Claims

1. , An electronic skin, **characterized by**:
comprising a capacitance-to-digital conversion circuit, a switch array, a processing module (200), and an electrode layer (100);
the electrode layer (100) is insulated and affixed to a first external object (600) for proximity sensing, and is provided with at least three sensing electrodes (101) distributed at different positions;
the capacitance-to-digital conversion circuit couples each sensing electrode (101) via the switch array to selectively connect any one or more sensing electrodes (101) in parallel, forming a self-capacitance detection electrode. Different selections create variations in the area of each formed self-capacitance detection electrode, thereby obtaining their respective self-capacitance values to form a combination; and/or selectively combines any two or more sensing electrodes (101) to form a pair of mutual capacitance detection electrode groups. Different selections create variations in the area or spacing between the two electrodes within each pair of mutual capacitance detection electrode groups, thereby obtaining the mutual capacitance values of each mutual capacitance detection electrode group to form a combination;
the processing module (200), coupled to the capacitance-to-digital conversion circuit, outputs the distance and/or speed at which a second external object approaches the electronic skin based on the combination.

2. , The electronic skin according to claim 1, **characterized in that**:
the electronic skin comprises at least two panels, each distributed across different regions of the first external object (600) and configured to operate in a time-division manner relative to one another.

3. , The electronic skin according to claim 2, **characterized in that**: digital signals are transmitted between each piece of electronic skin via a digital router.

4. , The electronic skin according to claim 1, **characterized in that**: the sensing electrodes (101) are configured as strip electrodes or mesh electrodes.

5. , The electronic skin according to claim 4, **characterized in that**: the surface of the first external object (600) possesses conductive capability.

6. , The electronic skin according to claim 4, **characterized in that** the open area ratio of the strip electrodes or mesh electrodes (101) is configured to be 50%-90%.

7. , The electronic skin according to claim 1, **characterized in that**: the electronic skin is provided with an outer insulating protective layer (300) and an inner insulating layer (400) laminated on both sides of the electrode layer (100), wherein the inner insulating layer (400) is configured to contact the first external object (600).

8. , The electronic skin according to claim 7, **characterized in that** the thickness of the inner insulating layer (400) is at least greater than 1 mm.

9. , The electronic skin according to claim 7, **characterized in that** the electronic skin further comprises an intermediate insulating layer (102) positioned between the electrode layer (100) and the inner insulating layer (400), and an active shielding layer (103) laminated onto the electrode layer (100) via the intermediate insulating layer (102).

10. , A robotic arm **characterized in that** an electronic skin as defined in any one of claims 1 to 8 is laminated onto the outer surface of the robotic arm (600).

11. , The robotic arm according to claim 10, **characterized in that** a capacitive sensor is configured on the probe (500) or operating head of the robotic arm (600).

12. , An intelligent robot, **characterized in that** it comprises a robotic arm as described in claim 10 or 11.
